# DEMANDE DE BREVET EUROPEEN

(11) **EP 0 870 855 A1**
(43) Date de publication de la demande: **14.10.1998**
(21) Numéro de dépôt: 98400833.4
(22) Date de dépôt: 07.04.1998
(51) Int. Cl.: C30B 11/00

(54) **Dispositif de cristallogènèse à piston**

(30) Priorité: 09.04.1997 FR 9704347
(71) Demandeur: COMMISSARIAT A L'ENERGIE ATOMIQUE, 75015 Paris (FR); CENTRE NATIONAL D'ETUDES SPATIALES, F-75039 Paris Cedex 01 (FR)
(72) Inventeur: Duffar, Thierry, 38000 Grenoble (FR); Dusserre, Pierre, 38120 Saint-Egreve (FR); Ostrogorsky, Alexandar, Troy, New York 12180 (US)
(74) Mandataire: Poulin, Gérard

(57) **Abrégé**

Dispositif de cristallogènèse à piston comprenant :
- un creuset (10) apte à contenir un germe (12) et un liquide (14) à solidifier recouvrant le germe ;
- des moyens (20) pour établir un gradient thermique dans le creuset ;
- un piston (14) mobile dans le creuset (10) dans une direction de croissance du cristal.

Conformément à l'invention, le dispositif comporte, en outre, des moyens de déplacement du piston (16) actionnables par le liquide (14) à solidifier.

## Description

### Domaine technique

La présente invention concerne un dispositif de cristallogènèse à piston. Ce dispositif est plus précisément adapté à la formation monodirectionnelle de cristaux dans un creuset.

Cette invention trouve des applications industrielles en cristallogènèse pour la formation de cristaux essentiellement semi-conducteurs, qui nécessitent une bonne homogénéité chimique. L'invention peut être mise en oeuvre, par exemple, pour la formation de cristaux de matériaux III-V tels que GaAs, InP, GaSb, InSb, ... ou de cristaux de matériaux II-VI, tels que CdTe, HgTe, ... et leurs alliages ternaires. De façon générale, l'invention peut être appliquée à tous les alliages métalliques ou réfractaires susceptibles d'être élaborés en creuset.

### Etat de la technique

La formation monodirectionnelle de cristaux dans un creuset est bien connue dans l'art antérieur. On connaît en particulier des méthodes de cristallogènèse désignées par méthode de "tirage Bridgman" ou "Gradient Freeze" (refroidissement sous gradient).

Un procédé de cristallisation visant à améliorer la qualité des cristaux obtenus par ces méthodes classiques est connu et décrit dans le document WO 91/02832. Le procédé décrit est mis en oeuvre de façon classique dans un creuset. A l'intérieur du creuset est placé un germe solide de matériau semi-conducteur recouvert de liquide du même matériau à solidifier. Le germe solide permet d'initier correctement la croissance d'un cristal.

Un élément chauffant est immergé dans le liquide au-dessus du germe. L'élément chauffant permet d'établir un gradient thermique dans le creuset. Grâce à ce gradient thermique, le liquide se solidifie, à partir du germe, pour former le cristal.

La solidification du liquide provoque le déplacement de la surface supérieure du cristal formé vers le haut du creuset. Dans la suite de la description, on désignera cette surface supérieure du cristal, en contact avec le liquide, par le terme "interface liquide/solide".

Afin d'obtenir un cristal homogène, il est nécessaire de maintenir l'élément chauffant à une distance constante de l'interface liquide/solide au cours de la cristallisation. A cet effet, des moyens mécaniques entraînent l'élément chauffant dans le sens de formation du cristal.

Une amélioration de cette méthode a été ultérieurement décrite dans l'article d'A. OSTROGORSKY et G. MULLER, paru dans le "Journal of Crystal Growth", 137 (1994), 64-71.

Conformément à cette amélioration, l'élément chauffant immergé dans le liquide à solidifier est remplacé par un simple piston, mobile dans le creuset, et déplacé de manière à rester à une distance constante de l'interface liquide/solide au cours de la formation du cristal. Le creuset est placé dans un four de croissance cristalline apte à créer un gradient thermique nécessaire à la formation du cristal. Le piston, immergé dans le liquide, est équipé d'un thermocouple pour mesurer sa température. Cette température qui dépend de la position du piston dans le creuset, permet notamment de déterminer si le piston se rapproche (diminution de température), ou s'éloigne (augmentation de la température) de l'interface liquide/solide.

Aussi le déplacement du piston, commandé par des moyens mécaniques relativement complexes est asservi à la température mesurée.

Une telle méthode de cristallisation à piston permet d'obtenir des cristaux plus homogènes que ceux obtenus par les méthodes classiques sans piston.

Cette méthode présente cependant plusieurs inconvénients. Elle utilise notamment des moyens mécaniques complexes et un dispositif de thermocouple coûteux. De plus, le thermocouple peut être sensible à des variations de température dans le four, faussant alors l'évaluation du déplacement de l'interface liquide/solide.

Par ailleurs, ce dispositif de l'art antérieur pose des problèmes de contamination du liquide à solidifier lors de la cristallisation.

### Exposé de l'invention

La présente invention a pour but de remédier à ces inconvénients en proposant un dispositif de cristallogènèse à piston, simple et peu coûteux qui permette d'obtenir des cristaux présentant une très bonne homogénéité.

Un but est en particulier de proposer un dispositif dans lequel le piston est maintenu à une distance constante du germe en croissance sans mesure de température dans le piston.

Un autre but de l'invention est de proposer un dispositif de cristallogènèse à piston empêchant toute contamination du liquide à solidifier.

La présente invention a plus précisément pour objet un dispositif de cristallogènèse à piston comprenant :
- un creuset apte à contenir un germe et un liquide à solidifier recouvrant le germe ;
- des moyens pour établir un gradient thermique dans le creuset ;
- un piston mobile dans le creuset dans une direction de croissance de cristal.

Conformément à l'invention, le dispositif comporte des moyens de déplacement du piston actionnables par le liquide à solidifier.

Le fonctionnement d'un tel dispositif repose pour l'essentiel sur la propriété qu'ont les semi-conducteurs de se dilater ou de se contracter lors de leur cristallisation. Au sens de la présente invention, on entend par "dilatation" la propriété qu'ont certains semi-conducteurs de présenter un volume à l'état solide qui est supérieur à leur volume à l'état liquide. Dans la suite de la description, on utilisera pour des raisons de simplification le terme "dilatation" pour désigner cette propriété.

Au sens de la présente invention également, on entend par "contraction", la propriété qu'ont certains semi-conducteurs de présenter un volume à l'état solide qui est inférieur à leur volume à l'état liquide. Dans la suite de la description, on utilisera pour les mêmes raisons de simplification le terme "contraction" pour désigner cette propriété.

On peut noter que le rapport volume solide sur volume liquide est une donnée connue ou déterminée de façon expérimentale, pour chaque semi-conducteur.

La variation de volume du matériau semi-conducteur lors de la cristallisation provoque un déplacement du niveau du liquide au fur et à mesure de la croissance du cristal, c'est-à-dire au fur et à mesure que l'interface liquide/solide monte dans le creuset.

L'invention propose d'utiliser ce mouvement du niveau du liquide pour déplacer le piston. Grâce à l'invention, des moyens de mesure de température du piston sont superflus.

Avantageusement, les moyens de déplacement du piston peuvent comporter un flotteur apte à flotter sur le liquide à solidifier et relié au piston.

Ce flotteur permet de restituer le déplacement du niveau du liquide dans le creuset au fur et à mesure de la croissance du cristal. Un tel dispositif est simple et beaucoup moins coûteux que les moyens de mesure de température de l'art antérieur.

Selon un mode de réalisation particulier de l'invention, les moyens de déplacement du piston peuvent comporter une tige de piston reliant de manière rigide, le piston au flotteur.

Le piston est donc directement entraîné par le flotteur dans son sens de déplacement. Un tel dispositif est adapté pour les cristaux se dilatant, car dans ce cas, le niveau du liquide monte dans le creuset, c'est-à-dire qu'il varie dans le même sens que l'interface liquide/solide. Cet agencement présente l'avantage d'une grande simplicité de construction ne nécessitant, de plus, aucune liaison mécanique extérieure au creuset.

Dans ce mode de réalisation, le creuset peut présenter une partie supérieure rétrécie dans laquelle le liquide peut pénétrer et dans laquelle s'étend une extrémité de la tige comportant le flotteur.

Cette caractéristique permet une variation du niveau du liquide dans la partie rétrécie plus importante que la variation du niveau du liquide dans le restant du creuset.

Le diamètre de cette partie rétrécie est adapté au diamètre du creuset et au rapport volume solide sur volume liquide. De cette façon, le déplacement du niveau du liquide dans la partie rétrécie peut être rendu proportionnel au déplacement de l'interface liquide/solide dans le creuset. Ainsi, le piston, entraîné par le flotteur, se déplace à la vitesse de déplacement de l'interface liquide/solide. Il est ainsi maintenu à une distance constante de celle-ci.

Avantageusement, des moyens additionnels peuvent être prévus pour chauffer cette partie supérieure afin d'éviter que le liquide qui monte dans cette partie ne se solidifie.

Selon un autre mode de réalisation de l'invention, les moyens de déplacement du piston peuvent comporter des moyens de transmission du mouvement reliant le flotteur au piston. Ces moyens de transmission du mouvement peuvent comporter une première crémaillère solidaire du flotteur, une seconde crémaillère solidaire du piston, et des engrenages à roues dentées en prise avec les première et seconde crémaillères.

Un tel mécanisme, de mise en oeuvre facile, a l'avantage de pouvoir être utilisé également pour des cristaux se contractant. Dans ce cas, le niveau du liquide dans le creuset baisse au fur et à mesure que le cristal croît. Le flotteur se déplace donc inversement au sens de déplacement de l'interface liquide/solide. Le dispositif à engrenages selon l'invention permet au flotteur d'entraîner le piston dans le sens de déplacement de cette interface liquide/solide. Le diamètre des roues dentées est adapté pour que la vitesse de déplacement soit proportionnelle à celle de l'interface liquide/solide.

De façon avantageuse également, le creuset peut être conçu sous la forme d'une ampoule étanche. Cette possibilité est offerte grâce à la simplification importante des moyens de déplacement du piston permise par l'invention. Il est ainsi possible d'éviter toute contamination extérieure du liquide à solidifier et du cristal obtenu.

Les caractéristiques et avantages de l'invention apparaîtront mieux au cours de la description qui va suivre. Cette description porte sur des exemples de réalisation donnés à titre explicatif, mais non limitatif, en référence aux dessins annexés.

### Brève description des figures

- La figure 1 représente un dispositif de cristallogènèse à piston dans une ampoule étanche selon un premier mode de réalisation de l'invention ;
- la figure 2 représente un dispositif de cristallogènèse à piston selon un deuxième mode de réalisation de l'invention.

### Exposé de modes référés de réalisation

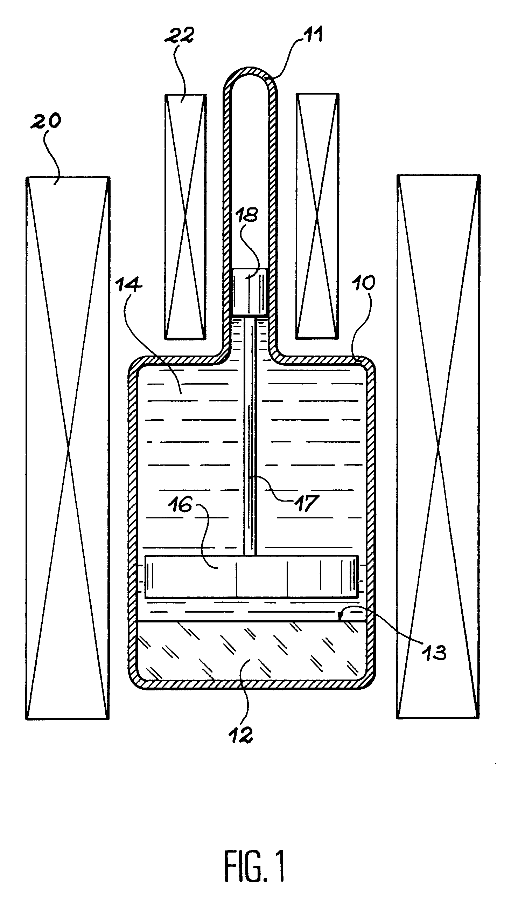

Le dispositif de cristallogènèse à piston, tel que représenté sur la figure 1, comporte un creuset (10), à l'intérieur duquel est placé un germe (12) de cristal initiateur de la croissance, recouvert de liquide (14) du même matériau à solidifier. Une interface (13) liquide/solide délimite la partie liquide (14) de la partie solide de cristal déjà formé.

Le germe (12) a généralement un diamètre égal à celui du creuset.

La formation du cristal est réalisée en plaçant le creuset (10) dans un four de croissance cristalline (20) dont seuls les éléments de chauffage sont représentés. Un gradient thermique est ainsi établi dans le creuset, pour permettre la solidification du liquide (14). La formation du cristal entraîne la montée dans le creuset de l'interface liquide/solide (13).

Le dispositif selon l'invention comprend un piston (16) immergé dans le liquide (14). Le piston (16) présente un diamètre externe légèrement inférieur à celui du creuset pour pouvoir coulisser dans le creuset, sans frottement. Le piston est maintenu à une distance constante de l'interface liquide/solide (13) de manière à permettre une croissance homogène du cristal.

Pour maintenir le piston à une distance constante de l'interface liquide/solide et donc déplacer le piston proportionnellement au mouvement de l'interface liquide/solide, l'invention propose d'utiliser la particularité qu'ont certains semi-conducteurs de se dilater (Si, Ge, GaSb, InSb, GaAs, ...) ou de se contracter (PbSe, PbTe, InTe) au cours de leur formation. Ces caractéristiques provoquent respectivement la montée ou la descente du niveau du liquide (14) dans le creuset. Le dispositif conforme à la figure 1 est adapté à la formation de cristaux qui se dilatent.

Un tel dispositif utilise un flotteur (18) relié rigidement au piston (16) par une tige (17). Le flotteur, situé sur le liquide (14), est en matériau léger, par exemple en graphite, pour flotter sur le liquide sans être mouillé.

Dans l'exemple illustré à la figure 1, au cours de la cristallisation, le niveau du liquide monte dans le creuset. Le flotteur (18) monte par conséquent aussi et entraîne le piston (16), auquel il est relié rigidement.

Du fait des caractéristiques de dilatation propres au cristal en formation et en raison des dimensions du creuset, le déplacement du niveau du liquide (14) n'est pas nécessairement proportionnel à celui de l'interface liquide/solide (13). Pour tenir compte de ce fait, l'invention, conformément à la figure 1, propose un creuset (10) avec une partie supérieure rétrécie (11) dans laquelle peuvent monter le liquide (14) et le flotteur (18). Cette partie (11) du creuset est adaptée au diamètre du creuset et au rapport volume solide sur volume liquide pour que le déplacement du flotteur soit égal à celui de l'interface liquide/solide. De cette façon, le piston est maintenu à une distance constante de l'interface (13) liquide/solide. Des moyens additionnels de chauffage (22) peuvent chauffer la partie rétrécie (11) du creuset afin d'éviter la solidification du liquide (14) qui monte dans cette partie.

On note que sur la figure 1, le creuset (10) se présente sous la forme d'une enceinte étanche. Il est ainsi adapté à la formation de cristaux sensibles à la pollution par la phase gazeuse tels que, par exemple, CdTe, GaAs et HgTe, en évitant toute contamination lors de leur formation.

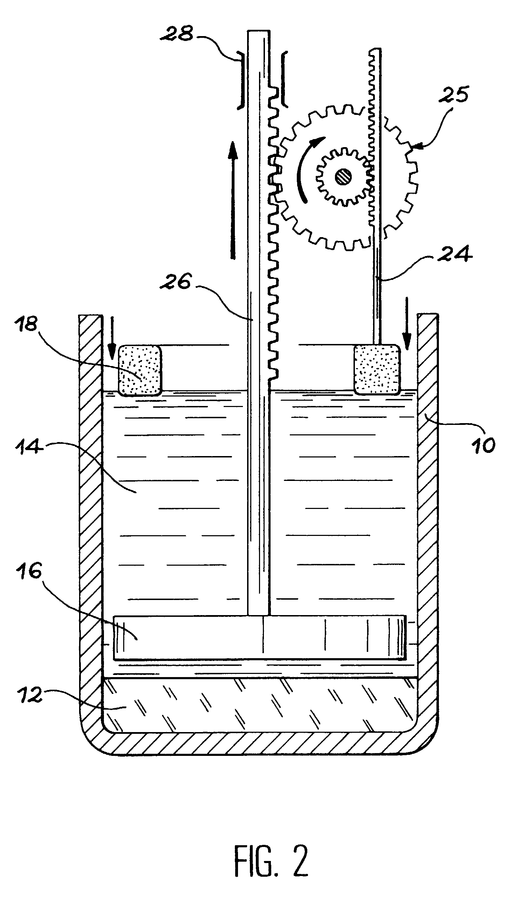

La figure 2 illustre un second mode de réalisation de l'invention. On retrouve des éléments communs au dispositif de la figure 1 : un creuset (10) contenant un germe (12) recouvert du liquide (14), un piston (16) et un flotteur (18).

Le dispositif représenté schématiquement sur cette figure est adapté aux cristaux se contractant. Dans ce cas, au cours de la cristallisation, le niveau du liquide baisse dans le creuset tandis que l'interface liquide/solide (13) monte. Le sens de déplacement du flotteur est donc inverse à celui de l'interface liquide/solide (13).

Des moyens mécaniques (24, 25, 26) reliant le flotteur au piston sont utilisés pour déplacer le piston (16) dans le même sens que l'interface liquide/solide (13).

Ces moyens mécaniques comportent une crémaillère (24) solidaire du flotteur. Le flotteur transmet le mouvement du liquide (14) à un engrenage (25) par l'intermédiaire de la crémaillère (24) . L'engrenage entraîne alors le piston (16) par l'intermédiaire d'une crémaillère (26) solidaire du piston.

Le diamètre des roues dentées de l'engrenage (25) est adapté au diamètre du creuset et au rapport volume solide sur volume liquide, pour que le mouvement transmis au piston (16) soit égal à celui de l'interface (13) liquide/solide.

Le déplacement du piston peut être maintenu vertical grâce à une pièce de guidage (28).

Une variante de ce dispositif à engrenages peut être envisagée pour des cristaux se dilatant. L'ajout d'une roue à engrenages, par exemple, permet d'entraîner le piston dans le sens de déplacement du flotteur. Cependant, dans ce cas, le dispositif conforme à la figure 1 est plus simple à mettre en oeuvre et est donc préconisé.

## Revendications

1. Dispositif de cristallogènèse à piston comprenant :
- un creuset (10) apte à contenir un germe (12) et un liquide (14) à solidifier recouvrant le germe (12) ;
- des moyens (20) pour établir un gradient thermique dans le creuset (10) ;
- un piston (16) mobile dans le creuset (10) dans une direction de croissance de cristal,
caractérisé en ce qu'il comporte, en outre :
- des moyens de déplacement du piston actionnables par le liquide (14) à solidifier.

2. Dispositif selon la revendication 1, caractérisé en ce que les moyens de déplacement du piston (16) comportent un flotteur (18) apte à flotter sur le liquide à solidifier (14) et relié au piston (16).

3. Dispositif selon la revendication 2, caractérisé en ce que les moyens de déplacement comportent, en outre, une tige (17) de piston reliant de manière rigide le piston (16) au flotteur (18).

4. Dispositif selon la revendication 3, dans lequel le creuset (10) présente une partie supérieure rétrécie (11) dans laquelle le liquide (14) peut pénétrer et dans laquelle s'étend une extrémité de la tige (17) comportant le flotteur (18).

5. Dispositif selon la revendication 4, caractérisé en ce qu'il comporte des moyens de chauffage additionnels (22) ménagés dans la partie supérieure rétrécie (11) du creuset (10).

6. Dispositif selon la revendication 2, caractérisé en ce que les moyens de déplacement du piston comportent des moyens de transmission du mouvement reliant le flotteur (18) au piston (16).

7. Dispositif selon la revendication 6, caractérisé en ce que les moyens de transmission du mouvement comportent :
- une première crémaillère (24) solidaire du flotteur (18) ;
- une seconde crémaillère (26) solidaire du piston (16) ; et
- des engrenages à roues dentées (25) en prise avec les première et seconde crémaillères.

8. Dispositif selon l'une quelconque des revendications 1 à 7, caractérisé en ce que le creuset (10) est une ampoule étanche.
